(19) **Europäisches Patentamt**

**European Patent Office**

**Office européen des brevets**

(11) Numéro de publication: **0 165 871**
**B1**

(12) **FASCICULE DE BREVET EUROPEEN**

(45) Date de publication du fascicule du brevet:
**11.05.88**

(51) Int. Cl.⁴: **B 23 K 37/04,** H 05 K 13/00

(21) Numéro de dépôt: **85401191.3**

(22) Date de dépôt: **14.06.85**

(54) **Procédé et dispositif pour la manipulation de plaquettes circulaires en vue de leur immatriculation par rayons laser.**

(30) Priorité: **18.06.84 FR 8409517**

(43) Date de publication de la demande:
**27.12.85 Bulletin 85/52**

(45) Mention de la délivrance du brevet:
**11.05.88 Bulletin 88/19**

(84) Etats contractants désignés:
**AT BE CH DE GB IT LI LU NL SE**

(56) Documents cités:
**FR - A - 2 474 001**
**GB - A - 1 443 215**
**US - A - 3 940 243**

(73) Titulaire: **SULZER ELECTRO-TECHNIQUE S.E.T. Société Anonyme dite:, Avenue de la Tour de Fer, F-74490 Saint-Jeoire (FR)**

(72) Inventeur: **Cavazza, Gilbert, Les Granges, F-74250 Viuz-En-Sallaz (FR)**

(74) Mandataire: **Bonnetat, Christian et al, Cabinet PROPI Conseils 23 rue de Léningrad, F-75008 Paris (FR)**

## Description

La présente invention concerne un procédé et un dispositif en vue de la manipulation mécanisée et automatique d'objets en forme de disques circulaires tels que des plaquettes de silicium et en vue de permettre l'exposition successive des disques ou plaquettes à un poste de travail notamment d'immatriculation par marquage au rayon laser.

L'invention concerne de façon plus particulière le processus de marquage en vue de leur immatriculation, aux fins d'identification ultérieure, des plaquettes de silicium constituées de disques circulaires plats et destinés à la fabrication de semi-conducteurs.

Il est en effet usuel afin de permettre l'identification des plaquettes individuelles de les immatriculer par une inscription. Ceci permet de suivre les plaquettes tout au long du processus de fabrication et de détecter facilement ou plus aisément, grâce à la mise en œuvre de moyens informatiques, des phases da faible rendement ou présentant un défaut dans le processus de fabrication.

On utilise à cet effet un rayon laser, émis depuis une source fixe et dont les émissions ponctuelles balaient la surface de marquage de façon à reporter sur le disque ou la plaquette, à l'endroit nécessaire, les successions de points constituant les références ou immatriculations permettant l'identification de la plaquette; le balayage de la surface de marquage et le déplacement des points correspondant au marquage est obtenu par le déplacement d'un jeu de miroirs de renvoi.

Il est nécessaire d'opérer ce marquage de façon automatique essentiellement pour des raisons de renement et de prix de revient, permettant ainsi d'utiliser les cadences élevées susceptibles d'être obtenues par les appareils de marquage eux-mêmes.

Il est donc nécessaire d'associer à l'appareil de marquage un dispositif de manipulation qui permet de positionner les disques successivement en position d'exposition convenable aux rayons laser, de façon que le marquage puisse s'opérer à l'emplacement voulu.

A cet effet, les plaquettes de silicium devant recevoir l'émission du rayon de marquage doivent être acheminées individuellement depuis un conteneur de stockage, notamment un panier ajouré de type connu, au poste de marquage et là elles doivent être orientées de façon à ce que le balayage par les émissions ponctuelles de rayons laser soit opéré et reporte le marquage à l'endroit convenu et opportun, afin de permettre notamment ultérieurement une lecture par des moyens automatiques.

A cet effet, les plaquettes de silicium comportent des repérages d'orientation qui sont constitués généralement d'un méplat sur la tranche de la plaquette; dans d'autres systèmes le moyen de repérage d'orientation est constitué d'une simple encoche.

Les systèmes connus doivent donc soit repositionner la plaquette de façon à obtenir son orientation convenable et le positionnement de la zone de marquage à l'endroit balayé par les émissions laser, soit, la plaquette étant positionné de façon indifférente, repérer l'orientation de la plaquette et amener l'axe du rayon laser de façon à venir balayer la zone de réception appropriée telle qu'elle se situe sur la plaquette.

Dans tous les cas, il est cependant nécessaire d'opérer la manipulation et le transfert des plaquettes depuis le conteneur de stockage jusqu'au poste de marquage.

Certains dispositifs utilisent des trains de courroies respectivement pour l'alimentation depuis le panier de stockage jusqu'au poste de marquage et ensuite pour l'évacuation de la plaquette après marquage vers un conteneur de stockage aval. Cependant le système de transfert par courroies présente des inconvénients en raison des risques de pollution liés au contact physique entre la matière de la courroie et la plaquette de silicium.

On connaît également des dispositifs de transfert par coussins d'air jusqu'au poste de marquage, le recentrage de la plaquette étant effectué également par coussins d'air. L'utilisation de coussins d'air nécessite cependant, pour éviter les risques de pollution, une ultra-filtration de l'air mis en circulation pour supporter la plaquette dans son déplacement.

De sorte que les systèmes actuellement existants présentent des inconvénients sérieux au niveau du transfert; le système à courroies présentant des risques de pollution par désagrégation de la matière des courroies tandis que le système à coussins d'air est délicat à mettre en œuvre étant donné la nécessité d'une filtration rigoureuse.

De plus, les systèmes actuellement existants présentent des lourdeurs au niveau de l'orientation de la plaquette par rapport au rayon laser.

Les systèmes qui orientent la plaquette par rapport au faisceau de marquage sont délicats et longs à mettre en œuvre et ralentissent par conséquent la cadence de production.

Les systèmes qui orientent l'émission du faisceau par rapport à la plaquette, après détection de positionnement de cette dernière par analyse d'images, sont plus rapides mais nécessitent cependant des installations encore lourdes et onéreuses.

La présente invention vise à remédier à ces inconvénients.

Un premier objet de l'invention est de réduire au minimum le déplacement des plaquettes pour assurer d'une part leur arrivée au poste de marquage et leur orientation par rapport à ce poste.

Ainsi l'invention permet par une opération simple et rapide et opérée sur une charge ou un ensemble de plaquettes, et non pas sur chaque plaquette individuellement, d'aboutir au positionnement correct d'une pluralité de plaquettes en supprimant les dispositifs de recherche du repère de positionnement et d'analyse d'images de chaque plaquette après sa mise en place.

On aboutit ainsi à une augmentation considérable des cadences de marquage.

Parallèlement, on réduit le prix de revient de l'ensemble ainsi que l'encombrement de la machine.

A cet effet l'invention concerne en premier lieu un procédé automatique de manipulation de plaquettes en forme de disques circulaires plats en vue de la présentation successive des plaquettes à un poste de marquage par rayon laser comportant les étapes suivantes:

a) lesdites plaquettes sont alignées l'une derrière l'autre dans des plans verticaux parallèles et maintenues dans un support;

b) le support est amené à un poste de travail comportant des moyens de calage en position déterminée du support et tel que les plans parallèles des plaquettes alignées verticalement soient sensiblement perpendiculaires à l'axe de projection du rayon laser de marquage;

c) les plaquettes sont déplacées successivement entre une position frontale et située dans le champ du rayon laser de marquage et une position dégagée par rapport à ce rayon;

d) d'une part les plaquettes alignées ensemble ou d'autre part la source d'émission du rayon laser de marquage sont déplacées pas à pas l'un par rapport à l'autre de façon, après chaque opération de marquage d'une plaquette et dégagement de cette plaquette selon le mouvement précédent, à amener une nouvelle plaquette non marquée en position de réception du rayon de marquage.

L'invention concerne également un dispositif pour la manipulation automatique de plaquettes de silicium en vue de leur présentation à un poste de marquage par rayon laser et dans lequel un support contenant ce plaquettes parallèles et alignées est annexé audit poste et les plaquettes sont déplacées successivement pour être exposées audit rayon laser de marquage, le support étant déplacé pas à pas après chaque opération de marquage et comportant:

a) des moyens pour supporter (1) des plaquettes circulaires maintenues alignées verticalement l'une derrière l'autre selon des plans parallèles;

b) un poste de calage (3, 3') en position déterminée dudit support et tel que le train de plaquettes soit aligné selon l'axe d'émission du rayon laser de marquage (7');

c) des moyens de déplacement réciproque du support et de l'alignement des plaquettes par rapport à la source d'émission du rayon laser, le déplacement étant linéaire selon l'axe dudit rayon et permettant d'amener successivement chaque plaquette à une distance fixe de la source d'émission;

d) des moyens de déplacement vertical (6) de certaines au moins des plaquettes entre une position haute dégagée par rapport au support et une position basse en appui sur le support.

D'autres caractéristiques et avantages de l'invention ressortiront de la description qui suit et qui est donnée en rapport avec des formes de réalisation présentées à titre d'exemples avec références aux dessins annexés.

La fig. 1 montre une vue en perspective et schématique du principe de fonctionnement du procédé et du dispositif selon l'invention dans une première forme de réalisation correspondant aux figures 1 à 5.

La fig. 2 représente une vue schématique montrant les phases successives du fonctionnement du dispositif et du procédé selon l'invention.

La fig. 3 montre une vue en coupe transversale du dispositif de l'invention selon la première forme de réalisation, dans une première phase.

La fig. 4 représente une vue en coupe transversale de cette première forme de réalisation dans une phase ultérieure du fonctionnement.

La fig. 5 représente la première forme de réalisation selon une vue transversale dans une troisième phase de son fonctionnement.

La fig. 6 représente une vue en coupe longitudinale du dispositif selon les figures 1 à 5.

La fig. 7 montre une vue de détails de réalisation du cylindre de réorientation des plaquettes.

La fig. 8 représente une vue en coupe transversale d'une seconde forme de réalisation à une phase initiale.

La fig. 9 représente une vue en coupe transversale de la seconde forme de réalisation à une phase ultérieure.

La fig. 10 représente une vue en coupe transversale de la seconde forme de réalisation à une phase ultérieure du mouvement de réorientation des plaquettes.

La fig. 11 montre une vue en coupe transversale d'une troisième forme de réalisation.

La fig. 12 montre une vue en coupe transversale de la troisième forme de réalisation à une phase ultérieure par rapport à la figure précédente.

La figure 13 montre une vue en coupe longitudinale du dispositif selon la troisième forme de réalisation.

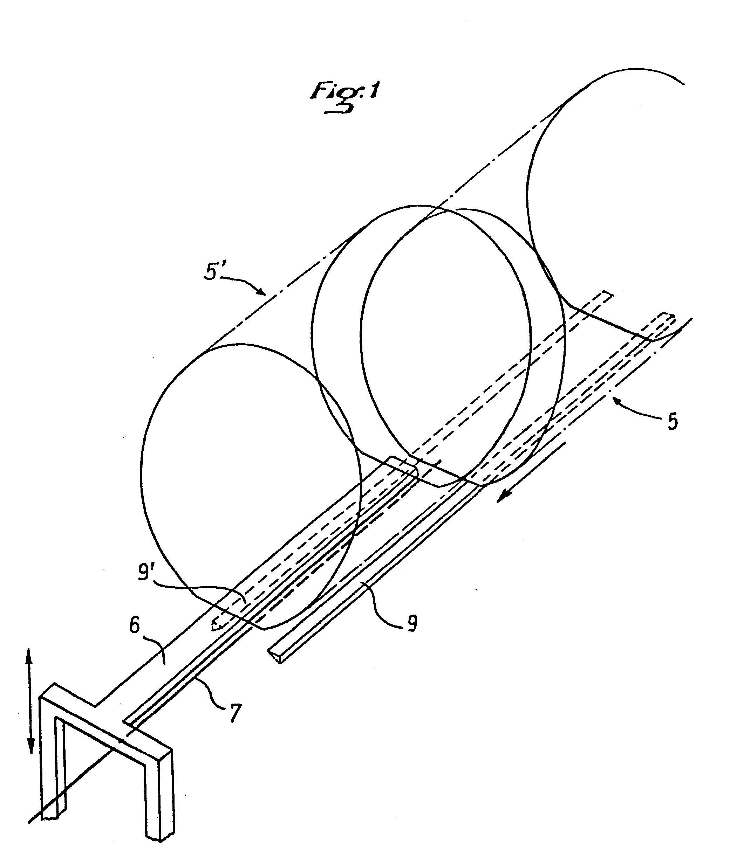

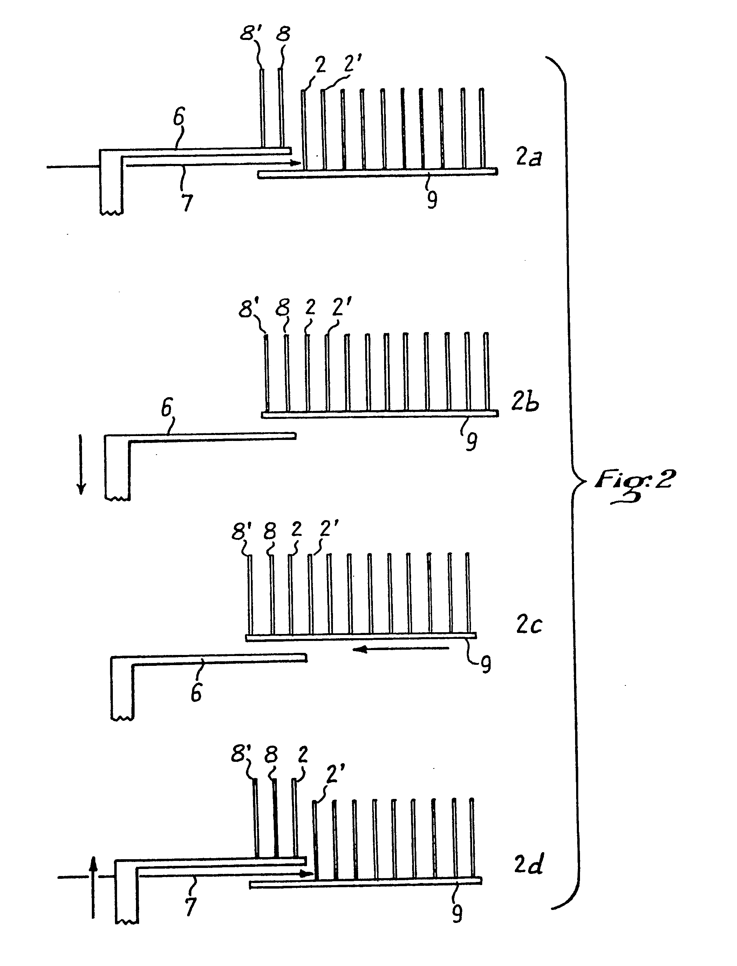

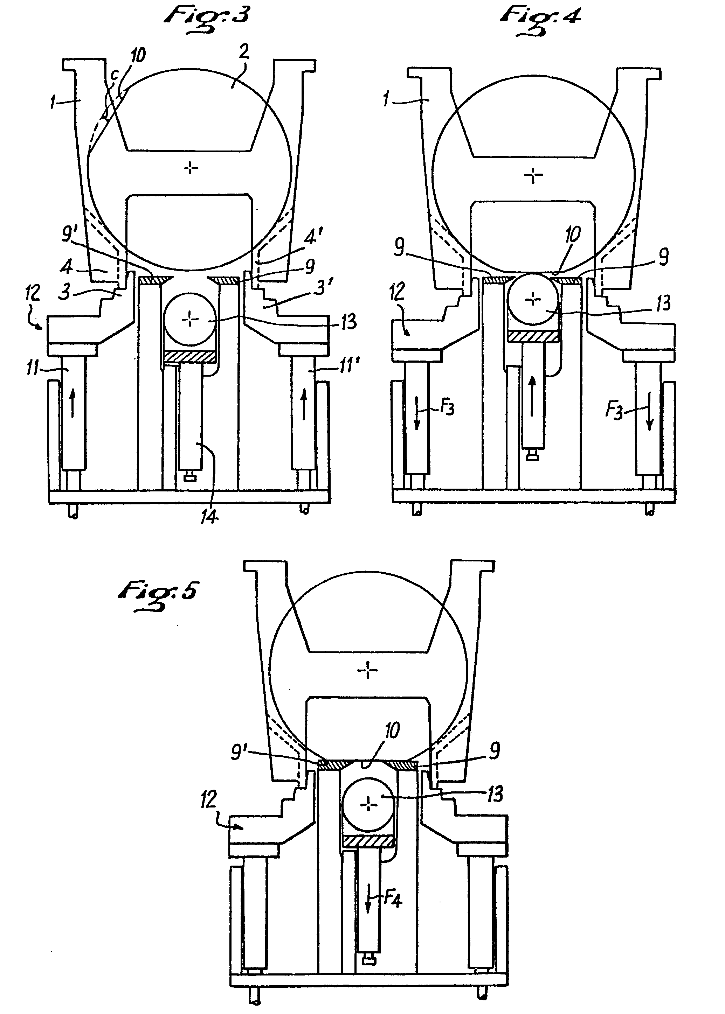

Les figures 1 et 2 montrent le schéma de principe montrant le déplacement des plaquettes d'une part co-linéairement par rapport à l'axe du rayon de marquage dans un avancement pas à pas et d'autre part verticalement dans le mouvement de dégagement des plaquettes marquées; cette forme de réalisation est illustrée de façon plus précise dans les figures 3 à 6 inclus.

Les plaquettes sont disposées verticalement sur tous supports convenables aptes à les maintenir espacées l'une de l'autre dans un alignement selon des plans parallèles et à intervalles réguliers.

On utilisera de préférence des paniers de stockage et de manipulation de type connu tel celui décrit dans le brevet US-3 923 156.

Ces supports 1 (figures 3 et suivantes) sont ajourés et offrent notamment un fond ouvert permettant l'accès et le contact depuis un organe inférieur sur les plaquettes 2, 2'.

La panier est réceptionné à un poste mobile constitué par exemple des rails parallèles 3 et 3' sur lesquels la base 4, 4' du panier 1 est apte à venir se positionner.

Les rails 3, 3' constituant le poste récepteur du support ou panier 1 est monté linéairement selon l'axe du rayon de marquage constitué d'un rayon laser 7 à émissions ponctuelles depuis une source non représentée et apte à balayer la surface de marquage pour y reporter la succession de points constituant le marquage ou immatriculation individuelle de chaque plaquette de silicium 2, 2', 8, 8' (fig. 2).

Le schéma général de fonctionnement du procédé et du dispositif selon l'invention est illustré aux figures 1 et 2.

A la fig. 1 on voit le train de l'ensemble des plaquettes 2, 2' décomposé en deux parties, respectivement 5, 5'.

La partie arrière 5 correspond aux plaquettes en attente de marquage tandis que la partie avant ' qui repose sur la palette élévatrice 6 est en position de dégagement et correspond aux plaquettes qui ont déjà été marquées.

On retrouve ces deux trains respectivement 5 et 5' schématisés sur les figures 2 (2a à 2d).

Et on voit de que l'élévation de la portion avant 5' d'une partie des plaquettes vise à dégager ces plaquettes déjà marquées par rapport au trajet du faisceau optique 7 correspondant au rayon laser de marquage qui vient frapper à l'emplacement voulu la plaquette 2 qui occupe la position de réception du marquage.

Par la suite et lorsque la plaquette 2 immatriculée la palette élévatrice 6 s'abaisse et les plaquettes avant 8, 8' sont ramenées en position inférieure et viennent reposer sur leur plan support constitué des réglettes 9, 9'.

Dans l'exemple représenté aux figures 1 à 5 les plaquettes comportent un méplat et reposent sur les réglettes d'appui 9 et 9' par le méplat 10 amené en position inférieure dans les conditions qui seront décrites ci-après, de sorte que toutes les plaquettes reposent sur les réglettes 9 et 9' par leur méplat amené en position basse.

Le fonctionnement se poursuit comme on le voit sur la fig. 2.

Après abaissement de la palette élèvatrice 6 l'ensemble de supportage constitué ici des réglettes 9 et 9' et y compris le panier ou conteneur 1 et le train de plaquettes est avancé d'un pas selon la flèche de la fig. 2c en direction de la source d'émission du rayon de marquage 7. De sorte que chaque plaquette occupe rigoureusement la position de la plaquette qui la précède et la plaquette 2' se trouve ainsi amenée dans la position occupée précédemment par la plaquette 2.

Dans ce mouvement la palette élévatrice 6 reste immobile.

Dans la phase ultérieure représentée à la fig. 2d la palette élévatrice 6 est animée d'un mouvement vertical selon la flèche de la fig. 2d et, en s'intercalant à l'intérieur des réglettes 9, 9' et elle est amenée en position haute ou position de dégagement au-dessus de l'axe du rayon 7.

Dans ce mouvement de relèvement la palette 6 entraîne avec elle les plaquettes qui sont au-dessus d'elle et on voit ainsi que la plaquette 2 a été amenée dans le mouvement d'avancement linéaire pas à pas de la fig. 2c au-dessus de la palette 6 et se trouve ainsi remontée avec cette dernière.

Et dans ces conditions la palette 6 remonte et amène en position de dégagement toutes les plaquettes antérieures à la plaquette 2 et libère la base de la plaquette 2' qui est ainsi mise en position d'exposition par rapport au rayon de marquage lequel peut balayer la zone appropriée à la base de la plaquette 2' pour opérer le marquage de cette dernière.

Ce mouvement est illustré notamment à la fig. 6 qui représente une vue en coupe longitudinale du dispositif et montre le mouvement de la palette 6, ici en position remontée et dégageant le faisceau 7.

Les plaquettes 2, 2', 8, 8' sont positionnées dans un panier ou conteneur 1 qui assure leur alignement lequel est monté sur le poste constitué des rails récepteurs 3 et 3' eux-mêmes solidaires de deux jambages latéraux 11 et 11'. L'ensemble ainsi constitué (fig. 6) est apte à subir un mouvement de translation selon la flèche F de la fig. 6 vers la source d'émission du rayon de marquage 7 comme on l'a indiqué précédemment.

Et le mouvement respectivement du poste 12 récepteur du support ou panier 1 contenant les plaquettes dans son mouvement d'avancement pas à pas selon la flèche F1 en direction de la source du rayon laser 7 d'une part et le mouvement vertical de la palette 6 selon la flèche F2 sont synchronisés par des moyens de contrôle de telle façon que le mouvement d'avancement selon la flèche F1 du poste contenant les plaquettes vers la source laser s'effectue lorsque la palette est en position basse ce qui permet de venir positionner la plaquette qui vient d'être marquée immédiatement au-dessus du bord de la palette en amenant cette plaquette en position de reprise par la palette de sorte que cette plaquette marquée va se trouver entraînée et remontée par la palette et amenée en position de dégagement.

Le dispositif de l'invention se combine à un système d'orientation des plaquettes qui est illustré aux figures 3, 4, 5 et 7 selon une première forme de réalisation.

Cette première forme de réalisation correspond au travail de manipulation des plaquettes comportant un méplat 10.

Il est usuel de reporter le marquage des plaquettes directement au-dessus du méplat 10.

Dans le cadre de l'invention, on va donc s'attacher à amener le méplat 10 en position inférieure de sorte que la partie située immédiatement en bordure du méplat 10 soit positionnée frontalement par rapport au rayon laser.

A cet effet le dispositif de l'invention selon cette première forme de réalisation comporte un ensemble d'orientation formé d'un cylindre tournant 13 monté sur un ensemble d'élévation 14.

Au départ du mouvement de réorientation des plaquettes le panier support 1 et son poste récepteur est légèrement élevé à partir des jambages 11, 11'.

Les réglettes 9 et 9' qui sont disposées intérieurement sous les plaquettes et sont engagées dans l'espace libre situé dans le fond du panier 1 ne sont pas affectées par ce déplacement et restent fixes.

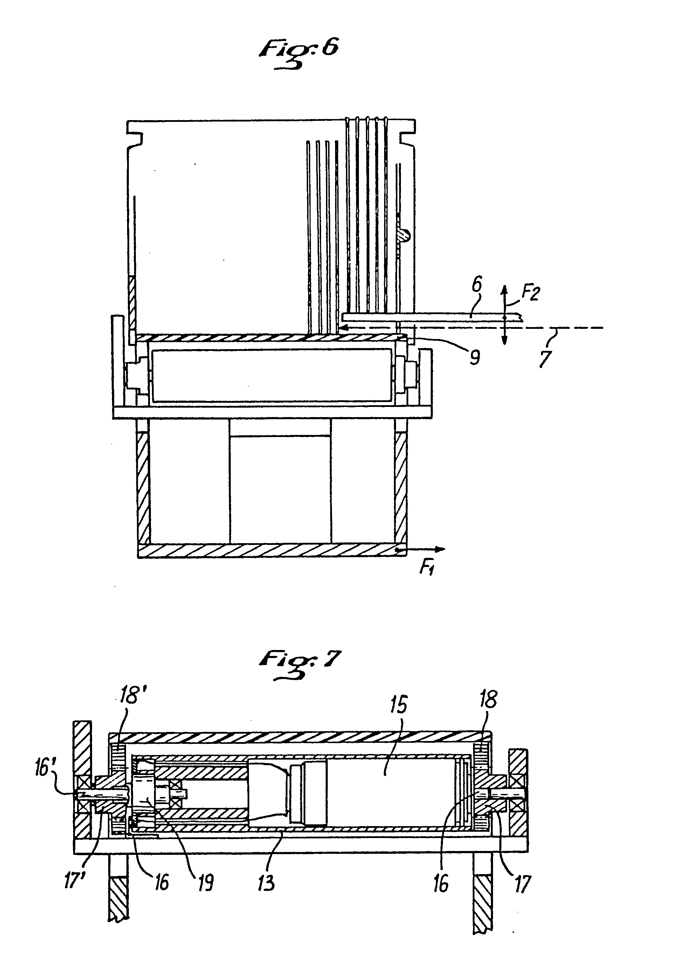

Après cela, le cylindre et son attelage élévateur 14 sont montés pour venir amener le cylindre 13 en position d'appui sur les diques 2 comme on le voit sur la fig. 4.

Dans ce mouvement d'élévation le cylindre 13 en appui sur le bord ou tranche des plaquettes 2 soulève l'ensemble des plaquettes d'une distance correspondant sensiblement à la corde c du méplat 10 (fig. 3).

Le cylindre est positionné à la base de l'alignement des plaquettes de telle façon que la ligne géométrique des points d'appui du cylindre 13 sur les plaquettes se situe dans le plan vertical de symétrie de l'ensemble des plaquettes; ainsi le cylindre est situé rigoureusement à la base inférieure des plaquettes.

Par simpe entraînement par friction du cylindre (à la paroi très lisse) sur la tranche des plaquettes, la rotation du cylindre 13 entraîne la rotation des plaquettes sur elles-mêmes et dans leur plan.

Lorsque le méplat 10 arrive en position d'appui sur le cylindre il en résulte un abaissement du niveau de la plaquette correspondante, abaissement correspondant à l'arc de la corde du méplat; dans ces conditions l'abaissement correspond à l'élévation provoquée antérieurement par le contact du cylindre et lorsque le méplat vient en appui sur le cylindre, il se trouve que la plaquette reprend sa position initiale c'est-à-dire qu'elle est au repos en appui sur les parois du panier 1; dans ces conditions, la rotation ultérieure du cylindre est insuffisante pour vaincre les forces de friction entre la tranche de la plaquette et les parois du panier en provoquant la remontée de la plaquette.

Et dans ces conditions, lorsque la plaquette a trouvé sa position de repos, le méplat 10 est en en appui sensiblement en son centre sur le cylindre, il reste dans cette position.

De sorte que après un nombre de rotation du cylindre correspondant au maximum à un tour de chaque plaquette, toutes les plaquettes se trouvent alignées, leur méplat étant en position inférieure.

Le poste 12 récepteur du panier 1 et de l'ensemble des plaquettes est alors abaissé selon les flèches F3 de la fig. 4 et les plaquettes viennent en appui sur les réglettes latérales 9, 9'.

Dans ces conditions et comme on le voit sur la fig. 5, les plaquettes sont rigoureusement alignées, leur méplat successif étant compris dans un plan unique et uniforme défini par les deux réglettes 9 et 9' et le cylindre de réorientation 13 peut alors être effacé vers le bas selon la flèche F4.

Ainsi, les plaquettes étant rigoureusement alignées il est possible de procéder aux opérations d'inscription avec le mouvement de dégagement vertical des plaquettes déjà marquées par la palette de dégagement 6 comme on l'a décrit précédemment et illustré aux figures 6 et 1 et 2.

La fig. 7 illustre un cas particulier de réalisation du cylindre 13.

Dans cet exemple le cylindre 13 est entrainé par un moteur intérieur 15 alimenté par le contact tournant 16.

L'arbre de sortie du moteur 15 est coaxial au cylindre 13 et cet arbre 16 est solidaire d'un pignon 17 engrené sur une piste verticale à crémaillère 18.

Du côté opposé on retrouve l'arbre 16' relié au cylindre 13 par l'intermédiaire d'un limiteur de couple 19.

Sur l'arbre 16' est monté le pignon 17' engrenant lui-même sur la crémaillère 18' symétrique de la crémaillère précédente 18.

Ainsi le moteur 15 permet d'assurer à la fois le mouvement de relèvement du cylindre 13 pour venir en position d'attaque sur la tranche des plaquettes d'une part et le mouvement de rotation du cylindre 13 sur lui-même d'autre part.

A cet effet après rotation initiale du moteur 15 entraînant l'arbre 16, le pignon 17 engrenant sur la crémaillère 18 assure la remontée de l'ensemble avec la rotation du cylindre 13 dans un sens; du côté opposé la rotation du cylindre 13 entraîne par l'arbre 16' la rotation du pignon 17' et sa montée sur la crémaillère 18'.

Après un certain mouvement ascendant lorsque le cylindre 13 a acquis sa position définitive de travail sur la tranche des plaquettes, une butée disposée par exemple sur la tige de guidage inférieure 14 immobilise l'ensemble en position haute.

Le moteur ne pouvant plus entraîner le cylindre sur la crémaillère 18 provoque alors la rotation du cylindre sur lui-même dans le sens inverse, la rotation du cylindre 13 étant possible par rapport à l'axe 16' (du côté opposé au moteur 15) grâce au jeu du limiteur de couple 19 permettant, au delà d'une certaine résistance, la rotation libre du cylindre.

Dans ces conditions, on voit que la mise en alimentation du moteur 15 provoque très simplement dans un premier temps l'amenée en position haute du cylindre c'est-à-dire dans sa position de travail pour la réorientation des plaquettes suivie de la rotation du cylindre 13 entraînant la rotation des plaquettes jusqu'à ce que leur orientation soit correctement effectuée comme indiqué précédemment.

Les figures 8, 9 et 10 illustrent une variante de réalisation du système de réorientation des plaquettes, dans le cas particulier où les plaquettes comportent un repère d'orientation constitué non plus d'un méplat mais d'une encoche 20.

Le système de réorientation comporte un cylindre 21 disposé parallèlement à l'axe d'alignement des plaquettes et apte à tourner sur lui-même. Ce cylindre est monté sur un équipage mobile 23 comportant par ailleurs un couteau 20'.

L'équipage mobile 23 portant d'une part le couteau 20' et d'autre part le cylindre d'entraînement 21 est monté à l'extrêmité d'un guidage 24 et une paroi 25 de l'attelage vient en appui par un effet de came sur un épaulement 26, l'équipage 23 étant articulé en 22 sur le support de guidage 24.

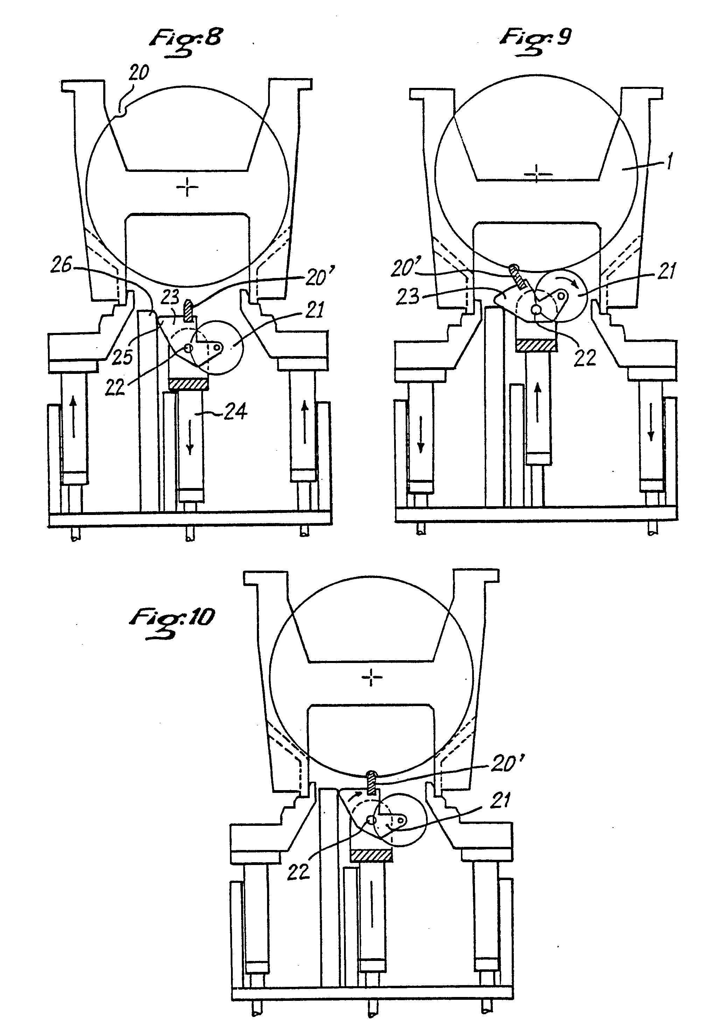

Lors du relèvement de l'équipage 23 porteur du cylindre 21 et du couteau 20 l'équipage est basculé par appui sur l'épaulement 26 et le couteau vient en position inclinée comme représenté à la fig. 9 tandis que le cylindre tournant 21 est en position d'appui sur la tranche des plaquettes qui sont légèrement soulevées par rapport à leur position de repos dans le conteneur ou panier 1.

Comme décrit précédemment le cylindre tournant 21 entraîne par friction les plaquettes qui sont ainsi entraînées en rotation sur elles-mêmes dans leur plan.

Cette rotation se poursuit jusqu'à ce que l'encoche 20 vienne d'engager sur le couteau 20' ou elle est alors en position d'appui formant butée s'opposant à toute rotation ultérieure de la plaquette.

Dans ces conditions après un nombre de rotations du cylindre 21 correspondant à une rotation entière des plaquettes toutes les encoches de toutes les plaquettes de l'alignement sont venues s'immobiliser sur le couteau 20'.

La rétraction vers le bas du couteau s'effectue avec basculement de l'attelage 23 toujours en appui sur l'épaulement 26 qui ramène le couteau dans une position médiane correspondant au plan vertical de symétrie des plaquettes; de sorte que l'ensemble des plaquettes est alors rigoureusement aligné toutes les encoches étant situées selon un axe parallèle à l'alignement des plaquettes et parallèle à l'axe du faisceau de marquage.

Les plaquettes étant ainsi alignées et convenablement orientées, l'action de marquage peut intervenir en commençant par la plaquette frontale qui est ensuite dégagée après avancement d'un pas de l'ensemble support, la plaquette frontale marquée étant, après avancement d'un pas, amenée ou-dessus de la palette de dégagement (précédemment décrite) et qui la relève pour exposer la plaquette immédiatement en arrière à l'action du rayon laser de marquage.

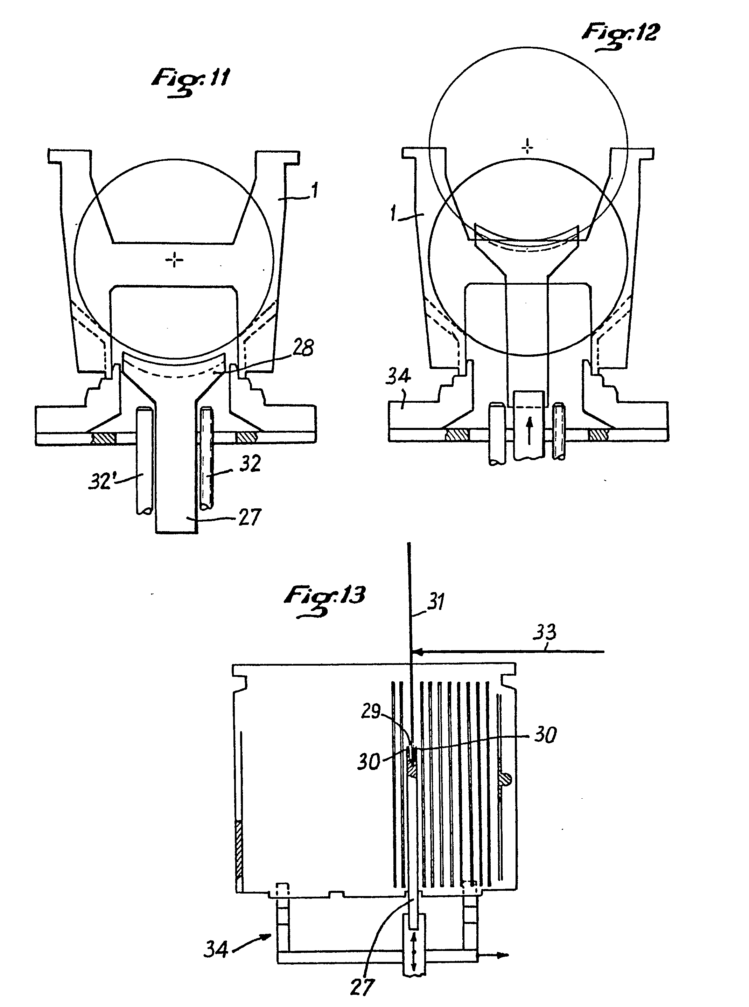

Les figures 11, 12 et 13 illustrent une variante dans laquelle les plaquettes positionnées dans leur panier support 1 sont soumises successivement à l'action d'un organe de préhension constitué d'un doigt 27 dont la partie supérieure en forme d'arc de cercle 28 comporte une gorge intérieure 29 apte à venir enserrer entre les bords 30, 30' la tranche de la plaquette 31.

Dans son mouvement de va-et-vient vertical le doigt 27 est guidé par les éléments latéraux 32, 32'.

Le doigt 27 après préhension de la plaquette 31 dans la gorge 29 est remonté pour amener la plaquette en position supérieure qui correspond ici à la position d'exposition au rayon 33 de marquage.

Dans cette forme de réalisation, chacune des plaquettes est appréhendée individuellement et successivement pour être dégagée du rang afin d'être amenée dans une position supérieure qui correspond à la position d'exposition au rayon de marquage.

Après quoi, le doigt de préhension 27 ramène la plaquette dans sa position initiale dans le rang.

L'ensemble constituant le poste 31 récepteur du conteneur ou panier 1 est susceptible de se déplacer pas à pas en direction de la source d'émission du rayon laser, le doigt de préhension 27 restant fixe et seulement animé d'un mouvement réciproque vertical; dans ces conditions, après avancement d'un pas du poste récepteur la plaquette arrière se trouve amenée en position occupée par la plaquette immédiatement en avant dans la phase précédente.

De sorte que après marquage d'une plaquette, la plaquette immédiatement en arrière (et qui n'est pas marquée) est avancée d'un pas pour venir en position de préhension au-dessus du doigt 27.

Dans la manoeuvre ultérieure le doigt appréhende la plaquette et l'amène en position haute pour subir l'opération de marquage après abaissement du doigt, l'ensemble du poste s'avance à nouveau pour amener une nouvelle plaquette au droit du doigt de préhension lequel va la soulever pour l'exposer à son tour au rayon de marquage.

Comme variante, l'avancement du poste supportant les plaquettes par rapport au rayon laser peut être effectué par déplacement de l'ensemble de ce poste par rapport à la source fixe tout comme il pourrait être obtenu par déplacement de la source d'émission par rapport au poste fixe contenant l'ensemble des plaquettes.

Le déplacement tant du panier 1 support des plaquettes (figures 3, 4 et 5) que de l'élévateur 27 (figures 11, 12, 13) peut être obtenu par un moteur électrique, par exemple du type pas à pas.

**Revendications**

1. Procédé automatique de manipulation de plaquettes (5, 5', 2, 2', 8, 8') en forme de disques circulaires plats en vue de la présentation successive des plaquettes à un poste de marquage par rayon laser (7) comportant les étapes suivantes:

a) lesdites plaquettes sont alignées l'une derrière l'autre dans des plans verticaux parallèles et maintenues dans un support (1);

b) le support (1) est amené à un poste de travail comportant des moyens de calage (3, 3') en position déterminée du support et tel que les plans parallèles des plaquettes alignées verticalement soient sensiblement perpendiculaires à l'axe de projection du rayon laser de marquage (7);

c) les plaquettes sont déplacées successivement entre une position frontale et située dans le champ du rayon laser de marquage et une position dégagée par rapport à ce rayon;

d) d'une part les plaquettes (5, 5') alignées ensemble ou d'autre part la source d'émission du rayon laser (7) de marquage sont déplacées pas à pas l'un par rapport à l'autre de façon, après chaque opération de marquage d'une plaquette et dégagement de cette plaquette (2) selon le mouvement précédent (c), à amener une nouvelle plaquette (2') non marquée en position de réception du rayon de marquage (7).

2. Procédé selon la revendication 1, caractérisé en outre en ce que le mouvement de déplacement des plaquettes entre leur position de marquage située dans le champ du rayon laser et la position dégagée par rapport audit rayon est effectué individuellement et successivement de sorte que chaque plaquette (31), après déplacement linéaire d'un pas du train de plaquettes par rapport à la source de rayon laser (33) de marquage, est déplacée individuellement de sa position dans le rang des plaquettes, correspondant à la position d'effacement par rapport au rayon laser, et est amenée en position extérieure par rapport à l'alignement des plaquettes, position extérieure correspondant à la position de marquage, et après l'opération de marquage la plaquette est ramenée dans le rang à sa position initiale.

3. Procédé selon la revendication 1, caractérisé en outre en ce que le support des plaquettes (1), constitué d'un panier ajouré de type connu, est introduit à un poste de travail comportant des moyens de blocage et de calage (3, 3') selon une position déterminée dudit support et tel que la première plaquette, en tête de l'alignement vers la source d'émission du rayon laser, soit ainsi exposée à l'action du rayon laser de marquage, le déplacement des plaquettes entre leur position de marquage et la position d'effacement étant effectuée verticalement et après chaque opération de marquage, l'ensemble des plaquettes (5') précédemment marquées étant déplacé verticalement vers une position haute de dégagement située hors du champ du rayon laser de marquage (7), en dégageant ainsi la face frontale de la plaquette ultérieure (2') ainsi exposée au rayon de marquage (7).

4. Procédé selon la revendication 1, caractérisé en ce que préalablement à la phase de marquage, il est procédé à une phase de réorientation des plaquettes de façon à amener la partie destinée à recevoir le marquage en position convenable par rapport au support des plaquettes et à l'axe du rayon laser de marquage, cette mise en position des plaquettes étant obtenue par rotation de ces dernières dans leur plan vertical et selon leur centre jusqu'à l'obtention d'une position correcte d'un repère d'orientation de la plaquette par rapport aux suppors.

5. Dispositif pour la manipulation automatique de plaquettes de silicium en vue de leur présentation à un poste de marquage par rayon laser et dans lequel un support contenant ces plaquettes parallèles et alignées est annexé audit poste et les plaquettes sont déplacées successivement pour être exposée audit rayon laser de marquage, le support étant déplacé pas à pas après chaque opération de marquage et comportant:

a) des moyens pour supporter (1) des plaquettes circulaires maintenues alignées verticalement l'une derrière l'autre selon des plans parallèles;

b) un poste de calage (3, 3') en position déterminée dudit support et tel que le train de plaquettes soit aligné selon l'axe d'émission du rayon laser de marquage (7');

c) des moyens de déplacement réciproque du support et de l'alignement des plaquettes par rapport à la source d'émission du rayon laser, le déplacement étant linéaire selon l'axe dudit rayon et permettant d'amener successivement chaque plaquette à une distance fixe de la source d'émission;

d) des moyens de déplacement vertical (6) de certaines au moins des plaquettes entre une position haute dégagée par rapport au support et une position basse en appui sur le support.

6. Dispositif selon la revendication 5, caractérisé en ce que les moyens de déplacement vertical des plaquettes comportent des organes de préhension tels qu'un doigt (27) muni d'une gorge (29) en V apte à venir appréhender par pincement la tranche d'une plaquette (31), l'organe de préhension étant animé d'un mouvement réciproque de va-et-vient et apte à retirer du rang des plaquettes en attente, une plaquette appréhendée individuellement et amenée dans une position excentrée correspondant à sa position d'exposition au rayon laser de marquage (33) et à ramener, dans un mouvement de retour, ladite plaquette dans sa position initiale dans le rang des plaquettes alignées.

7. Dispositif selon la revendication 5, caractérisé en ce que les moyens de déplacement vertical sont formés d'un élévateur constitué d'une palette (6) horizontale et montée sur un attelage à déplacement vertical et rendu entre une position basse de prise en charge sous une portion de l'alignement (5) des plaquettes, correspondant aux plaquettes à dégager, l'attelage vertical étant apte à amener cette portion des plaquettes en position haute supérieure et située hors du champ du rayon laser de marquage (7).

8. Dispositif selon l'une des revendications 5, 6 ou 7, caractérisé en ce que les moyens de déplacement horizontal de l'ensemble du train des plaquettes alignées par rapport à la source d'émission du rayon laser de marquage est constitué d'un support du type panier ajouré (1) connu en soi et apte à recevoir les plaquettes alignées verticalement et ces moyens de déplacement comportent en outre un poste récepteur (12) dudit support et pourvu de moyens de calage (3, 3') en position de ce dernier, le poste récepteur (12) étant monté mobile et déplaçable pas à pas linéairement selon l'axe du rayon de marquage (7).

9. Dispositif selon l'une des revendications 7 ou 8, caractérisé en ce qu'il comporte des moyens de commande aptes à synchroniser les mouvements respectivement du déplacement linéaire du poste mobile (12) par rapport à la source d'émission du rayon laser (7) et du déplacement vertical de la palette élévatrice (6), cette commande de synchronisation étant telle que la palette élévatrice soit ramenée en position basse ou de reprise lors du mouvement de déplacement linéaire du poste récepteur par rapport à la source de rayonnement, en amenant ainsi la partie appropriée du train de plaquettes en position de reprise par la palette élévatrice en vue de son dégagement, la première plaquette (2') suivant immédiatement la partie du train de plaquettes dégagées par la palette élévatrice étant ainsi amenée en position d'exposition au rayon laser de marquage (7).

10. Dispositif selon l'une des revendications 5 à 9, caractérisé en ce que, en vue de réorienter les plaquettes, de façon à positionner la partie convenable par rapport au rayon laser de marquage, il comporte deux réglettes (9, 9') en position fixe, parallèle, latérale et légèrement inférieure par rapport à l'axe du rayon laser de marquage, les réglettes étant solidaires du poste récepteur (12) du support ajouré (1) des plaquettes et mobile par rapport à la source d'émissions du rayon laser (7), les deux réglettes étant aptes à définir et constituer matériellement le plan d'appui des plaquettes en assise sur les deux réglettes par leur méplat (10), le dispositif comportant en outre des moyens mécaniques de mise en rotation des plaquettes et constitués d'un cylindre tournant (13) d'axe parallèle à l'alignement des plaquettes et apte à porter sur une partie au moins des plaquettes par leur tranchet et à entraîner leur rotation par friction jusqu'à ce que le méplat (10) vienne en appui stable sur les deux réglettes (9, 9').

11. Dispositif selon la revendication 10, caractérisé en ce que le cylindre (13) de mise en rotation des plaquettes est monté déplaçable entre une position effacée inactive et une position active dans laquelle le cylindre est en appui sur les tranches des plaquettes, et à la base de ces dernières, de telle sorte que la droite reliant les points de tangence du cylindre sur le train de plaquettes circulaires soit comprise dans le plan vertical de symétrie desdites plaquettes circulaires, les plaquettes étant légèrement soulevées, lors de leur mise en appui sur le cylindre d'une hauteur correspondant à l'arc de la corde constituée par le méplat par rapport à leur position de repos dans le support, tel que le panier, la rotation de chaque plaquette amenant finalement le méplat (10) en appui sur le cylindre (13) provoquant ainsi un léger abaissement de la plaquette (2) (d'une hauteur correspondant à l'arc de la corde constituée par le méplat) et en ramenant ainsi la plaquette (2) dans sa position de

13  **0 165 871**  14

repos sur les parois d'appui du panier (1) de stockage et en immobilisant la plaquette dans sa position, le méplat étant disposé horizontalement à sa partie inférieure.

12. Dispositif selon l'une des revendications 10 ou 11, caractérisé en ce que les réglettes (9, 9') sont elles-mêmes montées mobiles verticalement par rapport aux supports (1) des plaquettes de sorte que des réglettes soient déplaçables entre une position inférieure d'effacement par rapport aux supports lors de la mise en rotation des plaquettes par le cylindre (13) d'orientation et une position haute dans laquelle les réglettes sont amenées au contact des méplats (10) alignés des plaquettes (2) (en position inférieure dans le panier support) en soulevant légèrement lesdites plaquettes pour assurer leur assise horizontale selon un plan unique rigoureux.

13. Dispositif selon l'une des revendications 10, 11 ou 12, caractérisé en ce que le cylindre de réorientation (13) de plaquettes, comporte un moteur (15) disposé intérieurement audit cylindre et alimenté par contacts tournants, le moteur état apte d'une part à assurer le déplacement vertical du cylindre entre sa position inférieure d'effacement et sa position supérieure d'entraînement tangentiel au contact des tranches des plaquettes, le moteur étant apte d'autre part à assurer la rotation du cylindre sur lui-même, à cet effet, l'arbre moteur intérieur et coaxial au cylindre est relié à un arbre colinéaire de sortie extérieure (16) solidaire d'un pignon (17) engrenant sur une première crémaillère (18) verticale, le côté opposé du cylindre comporte un arbre de sortie coaxial (16') et relié au cylindre par un limiteur de couple, cet arbre étant récepteur d'un pignon (18') symétrique du précédent et engrenant sur une seconde crémaillère (18') verticale symétrique de la première, l'entraînement initial du moteur étant ainsi apte à provoquer le déplacement ascendant des pignons en prise sur les crémaillères jusqu'à une position haute maximum définie par une butée sur laquelle vient porter l'équipage mobile (14) porteur de l'ensemble cylindre, tandis qu'au-delà de cette position maximum l'action du moteur provoque la rotation du cylindre lui-même.

14. Dispositif selon l'une des revendications 4 ou 5, caractérisé en ce qu'il comporte un système de réorientation des plaquettes, lesdites plaquettes étant du type comportant un repère d'orientation (20) constitué d'une encoche disposée sur le bord des plaquettes, et ce dispositif comporte un système de mise en rotation des plaquettes par un cylindre (21) tournant d'axe parallèle au train des plaquettes, le cylindre étant monté effaçable entre une position dégagée et une position d'embrayage en appui sur les tranches des plaquettes ainsi aptes à être entraînées en rotation sur elles-mêmes, le cylindre coopérant avec une butée male mobile déplaçable entre une position active notamment inclinée, en contact avec les tranches des plaquettes, et une position d'effacement, le couteau (20') étant apte à recevoir les encoches (venant en appui sur ladite butée) amenées ainsi en position alignée, le déplacement ultérieur du couteau (20') retournant vers sa position d'effacement guidant les plaquettes vers une position stable et d'orientation uniforme en vue de la réception du marquage.

**Patentansprüche**

1. Automatisches Verfahren zur Bearbeitung von Scheiben (5, 5', 2, 2', 8, 8') in Form runder, flacher Plättchen in Hinsicht auf einen aufeinanderfolgenden Vorschub der Scheiben zu einer Kennzeichnungsstation mit Laserstrahl (7), gekennzeichnet, durch folgende Schritte:

a) die Scheiben werden eine hinter der anderen in senkrechten, parallelen Ebenen aufgereiht und in einer Halterung (1) gehalten;

b) die Halterung (1) wird einer Arbeitsstation mit Positioniermitteln (3, 3') an einer festgelegten Position der Halterung zugeführt, so dass die parallelen Ebenen der vertikal aufgereihten Scheiben etwa senkrecht zur Projektionsachse des Laserstrahls (7) zur Kennzeichnung verlaufen;

c) die Scheiben werden nacheinander zwischen einer vorderen, im Bereich des Laserstrahls liegenden Position und einer nicht von diesem Strahl beaufschlagten Position verschoben;

d) es werden einerseits die aufgereihten Scheiben (5, 5') zusammen oder die Laserstrahlungsquelle (7) zur Kennzeichnung Schritt für Schritt zueinander derart verschoben, dass nach jedem Kennzeichnungsvorgang einer Scheibe und Freigabe dieser Scheibe (2) gemäss Schritt (c) eine neue, noch nicht gekennzeichnete Scheibe (2') in die Beaufschlagungsposition des Kennzeichnungsstrahls (7) gebracht wird.

2. Verfahren nach Anspruch 1, dadurch gekennzeichnet, dass ausserdem die Vorschubbewegung der Scheiben zwischen ihrer im Bereich des Laserstrahls liegenden Kennzeichnungsposition und der von diesem Strahl nicht beaufschlagten Position einzeln und aufeinanderfolgend derart bewirkt wird, dass jede Scheibe (31) nach linearer Verschiebung um einen Schritt in der Reihe der Scheiben bezüglich der Laser-Strahlungsquelle (33) einzeln aus ihrer Position in der Reihe der Scheiben entsprechend der Nichtbeaufschlagungsposition des Laser-Strahls, verschoben wird und in eine ausserhalb der Aufreihung der Scheiben liegende Position, entsprechend der Kennzeichnungsposition, gebracht wird und nach dem Kennzeichnungsvorgang wieder in die Reihe in ihre Ausgangsposition zurückgeführt wird.

3. Verfahren nach Anspruch 1, dadurch gekennzeichnet, dass die Halterung der Scheiben (1), bestehend aus einem Korb mit Durchbrüchen bekannter Art, einer Arbeitsstation mit Mitteln zum Feststellen und Positionieren (3, 3') gemäss einer festgelegten Position dieser Halterung derart zugeführt wird, dass die erste Scheibe an der Spitze der Aufreihung zur Laser-Strahlungsquelle hin somit der Wirkung des Laserstrahls zur Kennzeichnung ausgesetzt wird, wobei die Verschiebung der Scheiben zwischen ihrer Kennzeichnungsposition und der Nichtbeaufschlagungsposition in senkrechter Richtung und nach jedem Kennzeichnungsvorgang bewirkt wird, wobei die Gesamtheit der vorher gekennzeichneten Scheiben (5') senkrecht in eine höhere, ausserhalb des Bereichs des Laser-Strahls zur Kennzeichnung (7) liegende Position verschoben wird, wobei somit die Vorderfläche der weiteren auf diese Weise dem

8

Kennzeichnungsstrahl (7) ausgesetzten Scheibe (2')
freigesetzt wird.

4. Verfahren nach Anspruch 1, dadurch gekennzeichnet, dass vor dem Kennzeichnungsvorgang ein Orientierungsvorgang für die Scheiben derart vorgenommen wird, dass der für die Kennzeichnung gewünschte Teil in eine geeignete Position bezüglich der Halterung der Scheiben und der Achse des Laser-Strahls für die Kennzeichnung gebracht wird, wobei diese Positionierung der Scheiben durch Drehung derselben in ihrer senkrechten Ebene und um ihren Mittelpunkt erreicht wird, bis eine korrekte Position einer Orientierungsmarkierung der Scheibe bezüglich der Halterungen erreicht ist.

5. Vorrichtung zur automatischen Bearbeitung von Silizium-Scheiben in Hinsicht auf ihren Vorschub zu einer Kennzeichnungsstation mit Laserstrahl, die eine Halterung mit parallelen und aufgereihten Scheiben enthält und wobei die Scheiben nacheinander verschoben werden, um dem Laserstrahl für die Kennzeichnung ausgesetzt zu werden, wobei die Halterung Schritt für Schritt nach jedem Kennzeichnungsvorgang verschoben wird, gekennzeichnet durch:

a) Mittel zum Halten (1) der runden, senkrecht eine hinter der anderen in parallelen Ebenen aufgereihten Scheiben;

b) eine Positioniereinrichtung (3, 3') in einer festgelegten Position der Halterung, wobei die Reihe der Scheiben mit der Strahlungsachse des Laserstrahls für die Kennzeichnung (7') ausgerichtet ist;

c) Mittel zur gegenseitigen Verschiebung der Halterung und der Aufreihung der Scheiben bezüglich der Strahlungsquelle des Laserstrahls, wobei die Verschiebung linear zur Achse des Strahls verläuft und es erlaubt, nacheinander jede Scheibe in einem festen Abstand von der Strahlungsquelle zuzuführen;

d) Mittel zum senkrechten Verschieben (6) von wenigstens einigen Scheiben zwischen einer höheren, nicht-beaufschlagten Position bezüglich der Halterung und einer niedrigeren, auf der Halterung abgestützten Position.

6. Vorrichtung nach Anspruch 5, dadurch gekennzeichnet, dass die Mittel zum senkrechten Verschieben der Scheiben Greifmittel umfassen, wie einen mit einer V-förmige Vertiefung (29) versehenen Finger (27), geeignet zum Fassen einer Scheibe (31) durch Klemmung, wobei das Greifmittel mit einem Element zur Hin- und Herbewegung versehen ist und geeignet ist, von der Aufreihung der Scheiben eine einzeln erfasste und in eine bezüglich ihrer Beaufschlagungsposition durch den Laserstrahl zur Kennzeichnung exzentrische Position (33) geführte Scheibe in Bereitschaft zu halten und die Scheibe in einer Rückwärtsbewegung in ihre ursprüngliche Position in der Reihe der aufgereihten Scheiben zurückzuführen.

7. Vorrichtung nach Anspruch 5, dadurch gekennzeichnet, dass die Mittel zum senkrechten Verschieben aus einem Aufzug mit einer waagerechten und auf einer Zugvorrichtung zum senkrechten Verschieben angebrachten Palette (6) bestehen, wobei die Zugvorrichtung zwischen einer niederen Position zum Beladen unter einem Teil der Aufreihung (5) der Scheiben, entsprechend den freizusetzenden Scheiben, beweglich ist, wobei die senkrechte Zugvorrichtung in der Lage ist, diesen Teil der Scheiben in eine höhere und ausserhalb des Bereichs des Laserstrahls für die Kennzeichnung (7) gelegene Position zu bringen.

8. Vorrichtung nach einem der Ansprüche 5, 6 oder 7, dadurch gekennzeichnet, dass die Mittel zum waagrechten Verschieben der Gesamtheit der Reihe von bezüglich der Strahlungsquelle des Laser-Strahls zur Kennzeichnung aufgereihten Scheiben aus einem an sich bekannten Korb mit Durchbrüchen (1) bestehen, der zur senkrechten Aufnahme der aufgereihten Scheiben geeignet ist, und dass diese Mittel zum Verschieben weiterhin eine Aufnahmestation (12) der Halterung umfassen, die mit Positioniermitteln (3, 3') in Position der letzterern versehen ist, wobei die Aufnahmestation (12) beweglich und linear Schritt für Schritt verschiebbar bezüglich der Strahlenachse für die Kennzeichnung (7) angebracht ist.

9. Vorrichtung nach einem der Ansprüche 7 oder 8, dadurch gekennzeichnet, dass sie Steuermittel zum Synchronisieren der Bewegungen zur linearen Verschiebung der beweglichen Station (12) zur Strahlungsquelle des Laser-Strahls (7) und der senkrechten Verschiebung der Aufzugspalette (6) umfasst, wobei diese Synchronisationssteuerung derart abläuft, dass die Aufzugspalette in eine niedere oder Wiederanlaufposition bei der linearen Verschiebungsbewegung der Aufnahmestation bezüglich der Strahlungsquelle zurückgeführt wird, wobei somit der geeignete Teil der Reihe von Scheiben in eine Wiederanlaufposition durch die Aufzugspalette in Hinblick auf eine Verschiebung gebracht wird, wobei die erste, sofort auf den durch die Aufzugspalette verschobenen Teil der Reihe von Scheiben folgende Scheibe (2') somit in eine Beaufschlagungsposition durch den Laser-Strahl zur Kennzeichnung (7) gebracht wird.

10. Vorrichtung nach einem der Ansprüche 5 bis 9, dadurch gekennzeichnet, dass sie in Hinblick auf die Reorientierung der Scheiben zur Positionierung des geeigneten Teils zum Laser-Strahl für die Kennzeichnung zwei Leisten (9, 9') in fester, paralleler, seitlicher und etwas tieferer Position zur Achse des Laser-Strahls zur Kennzeichnung umfasst, wobei die Leisten fest mit der Aufnahmestation (12) der Halterung (1) mit Durchbrüchen für die Scheiben verbunden und beweglich bezüglich der Strahlungsquelle des Laser-Strahls (7) sind, wobei die beiden Leisten die Abstützebene der Scheiben auf den Leisten durch ihre Abflachung (10) definieren und bilden, und dass die Vorrichtung weiterhin mechanische Mittel zum Rotieren der Scheiben umfasst, die aus einem in zur Aufreihung der Scheiben paralleler Achse drehenden Zylinder (13) bestehen, der die Scheiben wenigstens teilweise auf ihrer Kante erfassen kann und sie durch Reibung soweit drehen kann, bis die Abflachung (10) in stabile Abstützung auf die beiden Leisten (9, 9') kommt.

11. Vorrichtung nach Anspruch 10, dadurch gekennzeichnet, dass der Zylinder (13) für die Rotation der Scheiben verschiebbar zwischen einer nichtbeaufschlagten, inaktiven Position und einer aktiven Position angebracht ist, in der der Zylinder auf den Rändern der Scheiben und auf dem Sockel der letzteren abgestützt ist, so dass die die Tangentialpunkte des Zylinders mit der Reihe der runden Scheiben verbindende Gerade in der senkrechten Symmetrieebene der runden Scheiben liegt, wobei die Scheiben etwas angehoben werden bei ihrer Abstützung auf dem Zylinder von einer dem Bogen der durch die Abflachung gebildeten Sehne entsprechenden Höhe bezüglich ihrer Ruheposition in der Halterung, wie beispielsweise dem Korb, wobei die Rotation jeder Scheibe schliesslich die Abflachung (10) in Abstützung auf dem Zylinder (13) führt, wodurch ein leichtes Absenken der Scheibe (2) bewirkt wird (von einer Höhe entsprechend dem Bogen der durch die Abflachung gebildeten Sehne) und wodurch somit die Scheibe (2) in ihre Ruhestellung auf den Abstützwänden des Lagerkorbs (1) zurückgeführt und in ihrer Position festgesetzt wird, wobei die Abflachung waagrecht an ihrem Unterteil angeordnet ist.

12. Vorrichtung nach einem der Ansprüche 10 oder 11, dadurch gekennzeichnet, dass die Leisten (9, 9') selbst in senkrechter Richtung beweglich zu den Halterungen (1) der Scheiben derart angeordnet sind, dass die Leisten zwischen einer unteren, nichtbeaufschlagten Position bezüglich der Halterungen bei der Rotation der Scheiben durch den Zylinder (13) zur Orientierung und einer höheren Position verschiebbar sind, in der die Leisten in Kontakt mit den Abflachungen (10) in Aufreihung mit den Scheiben (2) gebracht werden (in einer tieferen Position im Haltekorb), wobei die Scheiben leicht angehoben werden, um ihren waagerechten Sitz in genau einer Ebene sicherzustellen.

13. Vorrichtung nach einem der Ansprüche 10, 11 oder 12, dadurch gekennzeichnet, dass der Reorientierungszylinder (13) für die Scheiben einen im Zylinder (13) angeordneten und mit drehenden Kontakten versehenen Motor (15) umfasst, wobei der Motor einerseits in der Lage ist, die senkrechte Verschiebung des Zylinders zwischen seiner unteren Nichtbeaufschlagungsposition und seiner oberen Position zum tangentialen Kontaktieren der Scheibenränder sicherzustellen, und wobei der Motor andererseits in der Lage ist, die Rotation des Zylinders um sich selbst sicherzustellen, zu welchem Zweck die koaxial zum Zylinder verlaufende Innenachse des Motors mit einer kolinearen Achse mit externem Ausgang (16) verbunden ist, die wiederum fest mit einem Ritzel (17) verbunden ist, der mit einer ersten senkrechten Zahnstange (18) zusammenwirkt, dass die entgegengesetzte Seite des Zylinders eine zum Zylinder koaxiale und mit ihm über einen Drehmomentbegrenzer verbundene Achse (16') umfasst, wobei diese Achse einen zum vorhergehenden symmetrischen Ritzel (17') aufnimmt, der mit einer zweiten senkrechten, zum ersten symmetrischen Zahnstange (18') zusammenwirkt, wobei der Antrieb des Motors somit in der Lage ist, die ansteigende Verschiebung der Ritzel in Eingriff mit den Zahnstangen bis zu einer höchsten, durch einen Anschlag definierten Position zu bewirken, an den das bewegliche, die Zylinderbaugruppe tragende Organ (4) anliegt, während jenseits dieser höchsten Position der Motor die Rotation des Zylinders selbst bewirkt.

14. Vorrichtung nach einem der Ansprüche 4 oder 5, dadurch gekennzeichnet, dass sie ein System zur Reorientierung der Scheiben umfasst, wobei die Scheiben eine Orientierungsmarkierung (20) aufweisen, die aus einer Einkerbung auf dem Rand der Scheiben besteht, und dass diese Vorrichtung ein System zur Rotation der Scheiben durch einen Zylinder (21) aufweist, der sich um eine zur Reihe der Scheiben parallele Achse dreht, wobei der Zylinder zwischen einer freigegebenen Position und einer Kuppelposition in Abstützung auf den Rändern der Scheiben angebracht ist, die somit in Rotation um sich selbst gebracht werden können, wobei der Zylinder mit einem beweglichen, zwischen einer aktiven, insbesondere geneigten Position in Kontakt mit den Scheibenrändern und einer Nichtbeaufschlagungsposition verschiebbaren Anschlag zusammenwirkt, wobei das Messer (20') die somit in aufgereihte Position geführten Kerben erfassen kann (in Abstützung auf dem Anschlag), wobei die weitere Verschiebung des in die Nichtbeaufschlagungsposition zurückkehrenden Messers (20') die Scheiben in eine stabile Position mit gleichmässiger Orientierung in Hinblick auf den Empfang der Kennzeichnung führt.

**Claims**

1. Process for automatically manipulating wafers (5, 5', 2, 2', 8, 8') in the form of flat circular discs for the purpose of successively offering the wafers at a station for marking by laser ray (7), comprising the following steps:

a) said wafers are aligned one behind the other in vertical, parallel planes and maintained in a support (1);

b) the support (1) is brought to a work station comprising means (3, 3') for wedging the support in determined position and such that the parallel planes of the vertically aligned wafers are substantially perpendicular to the axis of projection of the marking laser ray (7);

c) the wafers are displaced successively between a frontal position located in the field of the marking laser ray and a position cleared with respect to this ray;

d) on the one hand the wafers (5, 5') aligned together or on the other hand the source of emission of the marking laser ray (7) are displaced step by step one with respect to the other so as, after each operation of marking of a wafer and clearance of this wafer (2) in the preceding movement (c), to bring a new, non-marked wafer (2') in position for receiving the marking ray (7).

2. Process according to claim 1, characterized in addition in that the movement of displacement of the wafers between their position of marking located in the field of the laser ray and the position cleared with respect to said ray is effected individually and successively so that each wafer (31), after linear displacement by one step of the train of wafers with respect to the source of marking laser ray (33), is displaced individually from its position in the row of the wafers, corresponding to the position of retraction with respect to the laser ray, and is brought into outer position with respect to the alignment of the wafers, outer position corresponding to the position of marking, and after the operation of marking, the wafer is returned into the row in its initial position.

3. Process according to claim 1, characterized in addition in that the support of the wafers (1), constituted by a perforated basket of known type, is introduced at a work station comprising means (3, 3') for blocking and wedging said support in a determined position and such that the first wafer, at the head of the alignment towards the source of emission of the laser ray, is thus exposed to the action of the marking laser ray, the displacement of the wafers between their position for marking and the position of retraction being effected vertically and after each marking operation, the assembly of the wafers (5') previously marked being displaced vertically towards a high position of clearance located outside the field of the marking laser ray (7), thus clearing the frontal face of the subsequent wafer (2') thus exposed to the marking ray (7).

4. Process according to claim 1, characterized in that, prior to the marking phase, a phase of reorientation of the wafers is proceeded with so as to bring the part intended to receive the marking in suitable position with respect to the wafer support and to the axis of the marking laser ray, this positioning of the wafers being obtained by rotation of these latter in their vertical plane and at their centre until a correct position is obtained of a mark for orientation of the wafer with respect to the supports.

5. Device for automatically manipulating silicon wafers for the purpose of offering them at a station for marking by laser ray and in which a support containing these parallel, aligned wafers is annexed to said station and the wafers are displaced successively in order to be exposed to said marking laser ray, the support being displaced step by step after each marking operation and comprising:

a) means (1) for supporting the circular wafers maintained aligned vertically one behind the other in parallel planes;

b) a station (3, 3') for wedging said support in determined position and such that the train of wafers is aligned along the axis of emission of the marking laser ray (7');

c) means for reciprocating displacement of the support and the alignment of the wafers with respect to the source of emission of the laser ray, the displacement being linear along the axis of said ray and making it possible to bring each wafer successively at a fixed distance from the source of emission;

d) means (6) for vertical displacement of at least certain of the wafers between a high position cleared with respect to the support and a low position in abutment on the support.

6. Device according to claim 5, characterized in that the means for vertical displacement of the wafers comprise gripping members such as a finger (27) provided with a V-shaped groove (29) adapted to grip the edge of a wafer (31), the gripping member being animated by a reciprocating movement and adapted to remove from the row of stand-by wafers, a wafer gripped individually and brought into an eccentric position corresponding to its position of exposure to the marking laser ray (33) and to return, in a return movement, said wafer into its initital position in the row of aligned wafers.

7. Device according to claim 5, wherein the means for vertical displacement are formed by an elevator constituted by a horizontal pallet (6) mounted on a coupling with a vertical displacement and rendered mobile between a low position for taking over under a portion of the alignment (5) of the wafers, corresponding to the wafers to be cleared, the vertical coupling being adapted to bring this portion of the wafers into upper high position located outside the field of the marking laser ray (7).

8. Device according to one of claims 5, 6 or 7, characterized in that the means for horizontal displacement of the assembly of the train of aligned wafers with respect to the source of emission of the marking laser ray is constituted by a support of the perforated basket type (1) known per se and adapted to receive the vertically aligned wafers and these displacement means comprise in addition a station (12) for receiving said support and provided with means (3, 3') for wedging the latter in position, the receiving station (12) being mounted mobile and displaceable step by step linearly along the axis of the marking ray (7).

9. Device according to one of claims 7 or 8, characterized in that it comprises control means adapted to synchronize the movements respectively of the linear displacement of the mobile station (12) with respect to the source of emission of the laser ray (7) and of the vertical displacement of the elevator pallet (6), this synchronization control being such that the elevator pallet is returned into low or take-up position during the movement of linear displacement of the receiver station with respect to the source of radiation, thus bringing the appropriate part of the train of wafers into position of take-up by the elevator pallet for the purpose of clearance thereof, the first wafer (2') immediately following that part of the train of wafers cleared by the elevator pallet thus being brought into position of exposure to the marking laser ray (7).

10. Device according to one of claims 5 to 9, characterized in that, for the purpose of reorienting the wafers, so as to position the suitable part with respect to the marking laser ray, it comprises two strips (9, 9') in fixed, parallel, lateral position slightly lower with respect to the axis of the marking laser ray, the strips being fast with the receiver station (12) of the perforated support (1) of the wafers and mobile with respect to the source of emissions of the laser ray (7), the two strips being adapted to define and materially constitute the plane of support of the wafers supported on the two strips by their flat portion (10), the device further comprising mechanical means for rotating the wafers and constituted by a rotating cylinder (13) of axis parallel to the alignment of the wafers and adapted to bear on at least one part of the wafers by their edge and to bring about rotation thereof by friction until the flat portion (10) comes into stable abutment on the two strips (9, 9').

11. Device according to claim 10, characterized in that the cylinder (13) for rotating the wafers is mounted to be displaceable between an inactive retracted position and an active position in which the cylinder is in abutment on the edges of the wafers, and at the base of these latter, with the result that the straight line connecting the points of tangency of the cylinder on the train of circular wafers is included in the vertical plane of symmetry of said circular wafers, the wafers being slightly raised, during their abutment on the cylinder, by a height corresponding to the arc of the chord constituted by the flat portion with respect to their position of rest in the support, such as the basket, the rotation of each wafer finally bringing the flat portion (10) into abutment on the cylinder (13), thus provoking a slight lowering of the wafer (2) (by a height corresponding to the arc of the chord constituted by the flat portion) and thus returning the wafer (2) into its rest position on the support walls of the storage basket (1) and immobilizing the wafer in its position, the flat portion being disposed horizontally in its lower part.

12. Device according to one claims 10 to 11, characterized in that the strips (9, 9') are themselves mounted to be vertically mobile with respect to the supports (1) of the wafers so that the strips are displaceable between a lower position of retraction with respect to the supports during rotation of the wafers by the cylinder (13) for orientation and a high position in which the strips are brought into contact with the flat portions (10) aligned with the wafers (2) (in lower position in the supporting basket), slightly lifting said wafers to ensure horizontal support thereof along a strict single plane.

13. Device according to one of claims 10, 11 or 12, characterized in that the wafer reorientation cylinder (13) comprises a motor (15) disposed inside said cylinder and supplied by rotating contacts, the motor being adapted on the one hand to ensure vertical displacement of the cylinder between its lower position of retraction and its upper position of tangential drive in contact with the edges of the wafers, the motor being adapted on the other hand to ensure rotation of the cylinder on itself, to that end, the drive shaft inside and coaxial to the cylinder is connected to a colinear outer driven shaft (16) fast with a pinion (17) meshing on a first vertical rack (18), the opposite side of the cylinder comprises a coaxial driven shaft (16') and connected to the cylinder by a torque limiter, this shaft receiving a pinion (18') symmetrical to the preceding one and meshing on a second vertical rack (18') symmetrical to the first, the initial drive of the motor thus being adapted to provoke ascending displacement of the pinions in mesh on the racks up to a maximum high position defined by a stop on which abuts the mobile equipment (14) bearing the cylinder assembly, whilst, beyond this maximum position, the action of the motor provokes rotation of the cylinder itself.

14. Device according to one of claims 4 or 5, characterized in that it comprises a wafer reorientation system, said wafer being of the type comprising an orientation mark (20) constituted by a notch disposed on the edge of the wafers, and this device comprises a system for rotating the wafers by a rotating cylinder (21) of axis parallel to the train of the wafers, the cylinder being mounted retractable between a cleared position and a connected position in abutment on the edges of the wafers thus adapted to be driven in rotation on themselves, the cylinder cooperating with a mobile male stop displaceable between an active, particularly inclined position, in contact with the edges of the wafers, and a position of retraction, the cutter (20') being adapted to receive the notches (coming into abutment on said stop) thus brought into aligned position, the subsequent displacement of the cutter (20') returning towards its position of retraction guiding the wafers towards a stable position of uniform orientation for the purpose of receiving the marking.

## Fig.1

*Fig. 2*

*Fig. 3*

*Fig. 4*

*Fig. 5*

## Fig. 6

## Fig. 7

Fig:8

20
26
23
20'
25
21
22
24

Fig:9

1
20'
23
21
22

Fig:10

20'
21
22

*Fig.11*

*Fig.12*

1

28

32'

32

27

34

*Fig.13*

31

33

29

30

30

34

27